# EUROPÄISCHE PATENTSCHRIFT

(11) **EP 2 453 498 B1**
(45) Veröffentlichungstag und Bekanntmachung des Hinweises auf die Patenterteilung: **27.07.2016**
(21) Anmeldenummer: 12154922.4
(22) Anmeldetag: 17.01.2008
(51) Int. Cl.: H01L 51/52

(54) **Strahlungsemittierende Vorrichtung und Verfahren zur Herstellung einer strahlungsemittierenden Vorrichtung**
Radiation emitting device and method for manufacturing a radiation emitting device
Dispositif émettant un rayonnement et procédé de fabrication d'un dispositif émettant un rayonnement

(30) Priorität: 17.01.2007 DE 102007002404; 03.04.2007 DE 102007016081
(43) Veröffentlichungstag der Anmeldung: 16.05.2012
(62) Teilanmeldung aus: 08707967.9
(73) Patentinhaber: OSRAM OLED GmbH, 93049 Regensburg (DE)
(72) Erfinder: Pätzold, Ralph, 91154 Roth (DE); Sarfert, Wiebke, 91074 Herzogenaurach (DE); Gaerditz, Christoph, 80939 München (DE); Mäder, Alexander, 97794 Rieneck (DE)
(74) Vertreter: Epping - Hermann - Fischer

(56) Entgegenhaltungen:
- EP-A- 1 684 550
- WO-A-2005/041217
- DE-B3-102004 013 449
- JP-A- 2003 203 683
- US-A1- 2004 266 073
- US-A1- 2005 120 902

## Beschreibung

Die Erfindung betrifft eine strahlungsemittierende Vorrichtung gemäß Anspruch 1 und ein Verfahren zu deren Herstellung.

Die Elektrodenschichten der strahlungsemittierenden Vorrichtung sind semitransparent oder transparent für die von der Funktionsschicht emittierte Strahlung. Die erzeugte Strahlung kann somit durch die erste und/oder zweite Elektrodenfläche hindurch emittiert werden. Gegenüber Elektrodenflächen, die aus reinen Metallen bestehen und nicht transparent sind, weisen Elektrodenflächen, die neben Metallen noch weitere Bestandteile aufweisen und transparent sind, eine geringere Leitfähigkeit auf. Die an den Kontaktierungen zu den Elektrodenschichten angelegte Spannung fällt mit zunehmendem Abstand von der Kontaktierung ab und führt somit zu einer abfallenden Leuchtdichte der strahlungsemittierenden Vorrichtung.

Strahlungsemittierende Vorrichtungen, wie zum Beispiel eine OLED, sind anodenseitig zum Beispiel mit Indium Zinn Oxid ausgeführt. Dieser Werkstoff ist als Anodenwerkstoff für Leuchtdioden, insbesondere organische Leuchtdioden, so genannte OLED, aufgrund seiner Transparenz gut geeignet, bringt aber den Nachteil mit sich, eine nicht ausreichende Leitfähigkeit aufzuweisen, um eine homogene Stromverteilung an der Anode zu erreichen. Insbesondere für großflächige OLEDs für Beleuchtungszwecke ist eine homogene Stromverteilung über die Elektroden von Bedeutung, da sich damit auch eine homogene Leuchtstärke über die Fläche der OLED einstellt.

Der Spannungsabfall der strahlungsemittierenden Vorrichtung kann somit durch die Leitfähigkeit einer oder beider, also der ersten und zweiten Elektrodenschicht bedingt sein. Die erste und/oder zweite Elektrodenschicht kann dabei eine semitransparente oder eine transparente Elektrodenfläche sein, die strahlungsemittierende Funktionsschichten einschließt. Dabei kann auch eine der beiden Elektrodenflächen eine reflektierende Elektrodenfläche sein. Die Leitfähigkeit der transparenten Elektrodenflächen kann um zwei bis drei Größenordnungen eingeschränkt gegenüber der Leitfähigkeit einer reflektierenden Elektrodenfläche sein. Bei derartigen Elektrodenflächen kann es zu einem Spannungsabfall kommen, der mit größer werdendem Abstand zu den Kontaktierungen der ersten und/oder zweiten transparenten Elektrodenfläche zunimmt und somit zu einer schwächer werdenden Leuchtdichte führen kann. Die ausgestrahlte Strahlung, zum Beispiel das ausgestrahlte Licht, ist somit nicht homogen, sondern weist Unterschiede in der Dichte, zum Beispiel der Leuchtdichte auf.

Um eine möglichst homogene Stromverteilung zu erreichen, werden direkt auf die Anode, beziehungsweise Indium Zinn Oxid, ITO, dünne Metalllinien aufgebracht. Diese homogenisieren die Stromverteilung über die Anodenfläche und ermöglichen so eine homogenere Leuchtstärkenverteilung über die gesamte OLED Fläche. Die dünnen Metalllinien werden durch Lithografieprozesse und nachfolgenden nasschemischen Ätzverfahren direkt auf einem Substrat, zum Beispiel Glas, aufgebracht. Somit werden aus einem Metallmultischichtsystem die dünnen Metalllinien herausgebildet. Alternativ ist zur Bildung der Metalllinien auch ein Maskenprozess möglich, bei dem direkt auf das Substrat die Metallschicht aufgedampft beziehungsweise gesputtert wird. Diese Verfahrensweisen sind aufwändig und teuer und erhöhen damit die Produktionskosten für eine derartige strahlungsemittierende Vorrichtung.

Derartige Metalllinien, die aus Metallpartikeln ausgebildet sind, werden beispielsweise in der Druckschrift US 2007/079869 A1 beschrieben.

Es ist somit Aufgabe der Erfindung, die Herstellungskosten von strahlungsemittierenden Vorrichtungen zu senken.

Diese Aufgabe wird durch die in den nebengeordneten Patentansprüche angegeben Maßnahmen gelöst. Die untergeordneten Patentansprüche bilden diese Lösung in vorteilhafter Weise weiter.

Dabei ist eine strahlungsemittierende Vorrichtung vorgeschlagen, welche ein strahlungstransparentes Substrat und eine auf dem Substrat angeordnete Schichtfolge umfasst.
Die strahlungsemittierende Vorrichtung umfasst weiter zumindest eine erste Elektrodenschicht, welche als Anode bezeichnet werden kann, mit einer ersten Kontaktierung zum Anlegen einer elektrischen Spannung. Weiter umfasst die strahlungsemittierende Vorrichtung zumindest eine Funktionsschicht, welche im Betrieb Strahlung emittiert, und zumindest eine zweite Elektrodenschicht, welche als Kathode bezeichnet werden kann, mit einer zweiten Kontaktierung zum Anlegen einer elektrischen Spannung. Die zweite Elektrodenschicht ist auf der Funktionsschicht angeordnet. Die Funktionsschicht ist dabei zwischen der ersten und der zweiten Elektrodenschicht angeordnet.
Es ist vorgeschlagen, zumindest eine elektrisch leitende Bahn mittels leitfähiger Partikel, welche zueinander in elektrischem Kontakt stehen, zu bilden. Eine auf solche Weise gebildete elektrisch leitende Bahn lässt sich vorteilhafterweise durch ein Druckverfahren, insbesondere ein Siebdruckverfahren, herstellen. Zur Durchführung des Siebdruckverfahrens wird eine geeignete Druckpaste ausgewählt. Geeignet sind zum Beispiel Druckpasten, welche zum Beispiel in der Leiterplattenfertigung zur Anwendung kommen. Dies sind zum Beispiel Druckpasten, welche Suspensionen auf Basis von wässrigen oder alkoholhaltigen Lösungsmitteln mit leitfähigen Partikeln umfassen. Dabei sind die leitfähigen Partikel kleiner als 1 µm. Als leitfähige Partikel kommen Metallpartikel wie zum Beispiel Silberpartikel, Aluminiumpartikel oder Partikel aus anderen Metallen zur Anwendung. Um eine elektrisch leitfähige Bahn auszubilden müssen diese Partikel nach dem Siebdruckprozess in direktem Kontakt zueinander stehen. Dies lässt sich laut Anspruch 13 dadurch unterstützen, dass ein dem Druckvorgang nachfolgender thermischer Verfahrensschritt ein Verschmelzen der Partikel und damit zudem noch ebenso ein rückstandsfreies Entfernen der Lösungsmittel der Paste ermöglicht.

Vorteilhaft an dieser Vorgehensweise ist, dass die leitfähigen Bahnen gegenüber den bisherigen Verfahrensweisen deutlich günstiger herstellbar sind. Dies begründet sich dadurch, dass einige aufwändige Verfahrensschritte, welche nach den bisher bekannten Verfahren erforderlich waren, entfallen. So entfällt zum Beispiel ein großflächiges Aufbringen einer metallischen Schicht, welche im Anschluss wiederum aufwändig mittels Fotolithografie und Ätzverfahren strukturiert werden muss. Auch das dazu alternative Aufdampfen beziehungsweise Sputtern von metallischen Schichten durch Schattenmasken kann somit entfallen und wird durch das Siebdruckverfahren ersetzt. Somit entfällt also auch die aufwändige Herstellung in einem Hochvakuumbereich.
Die vorgeschlagene Verfahrensweise eignet sich nicht nur für die auch als Busbars bezeichneten elektrisch leitfähigen Bahnen, sondern ebenso für die Herstellung einer Kontaktierung der ersten oder zweiten Elektrodenschicht. Diese als Hilfsmetallisierung bezeichnete Kontaktfläche dient zum Anlegen einer elektrischen Spannung an das strahlungsemittierende Element.

Die Erfindung sieht vor, die elektrisch leitfähige Bahn mit einer strahlungstransparenten Schutzschicht zu überdecken, welche aus anorganisch leitendem Oxid, nämlich aus ZnO, besteht. Eine solche Schicht verhindert das Oxidieren der elektrisch leitfähigen Bahn beziehungsweise der Metallpartikel, welche die elektrisch leitfähige Bahn bilden. Ein Risiko zur Oxidation der Bahn beziehungsweise der Metallpartikel besteht im Wesentlichen bei nachfolgenden Reinigungsprozessen innerhalb des Herstellungsverfahrens der strahlungsemittierenden Vorrichtung. Ein weiterer Vorteil der Zinkoxidschicht ist, dass aufgrund der Halbleitereigenschaften der Zink-Oxid-Schicht die Austrittsarbeit, das heißt der an den elektrisch leitfähigen Bahnen, den Busbars erfolgende Ladungsträgeraustausch mittels der Zinkoxidschicht steuerbar ist.

Die elektrisch leitfähigen Bahnen sind somit mit der Elektrodenfläche der lichtemittierenden Vorrichtung kombiniert und sind mit zeitlich variablen und/oder mit unterschiedlich hohen Strömen ansteuerbar. Dadurch erhält man eine lichtemittierende Vorrichtung mit zeitlich variabel einstellbarer Leuchtdichte. Die strahlungsemittierende Vorrichtung weist ein Substrat auf, auf dem eine erste Elektrodenfläche aufgebracht ist. Darauf befinden sich mindestens zwei elektrisch leitfähige Bahnen, die im elektrischen Kontakt mit der ersten Elektrodenschicht stehen. Auf den elektrisch leitfähigen Bahnen befinden sich zumindest eine strahlungsemittierende Funktionsschicht und darauf eine zweite Elektrodenschicht. Die emittierte Strahlung liegt dabei im Bereich des für Menschen sichtbaren Lichtes. Die mindestens zwei elektrisch leitfähigen Bahnen sind dabei so eingerichtet, dass sie mit zeitlich variablen und/oder unterschiedlichen hohen elektrischen Strömen angesteuert werden können, wobei eine variierende Leuchtdichte resultiert. Durch die Pulsform, Steilheit, Höhe und Taktung des angelegten Stroms kann eine vorhandene nichtlineare Abhängigkeit der Leuchtdichte zur Dynamisierung der Beleuchtung genutzt werden. Die individuelle elektronische Ansteuerung erlaubt eine Anpassung an die gewünschte Belebtheit.

Diese Belebtheit bzw. Vitalität der Beleuchtung kann durch eine örtliche Fluktuation der Helligkeit erzeugt werden. Die Fluktuation kann örtlich statisch oder dynamisch hervorgerufen sein. Dadurch kann das Auge eine Raumtiefe auflösen und zusätzlich eine Lebendigkeit der Raumbeleuchtung erfahren.

Bei der strahlungsemittierenden Vorrichtung mit variabler Ansteuerung kann es sich in einer vorteilhaften Ausführung der Erfindung auch um eine OLED handeln, vorzugsweise um eine großflächige OLED. Das Material der Funktionsschicht kann Polymere und/oder Small Molecules umfassen.

Eine OLED umfasst eine erste und zweite Elektrodenschicht, wobei die eine als Kathode und die andere als Anode geschaltet sein können. Zwischen den beiden Elektrodenschichten befindet sich mindestens eine organische funktionelle Schicht, die z. B. eine Emissions-, eine Elektronen- und eine Lochtransportschicht beinhalten kann. Von der Kathode werden Elektroden und von der Anode positive Ladungen (sog. Löcher) in die Emissionsschicht bei Anlegen einer Spannung injiziert. Durch die Rekombination dieser Ladungen in der Emissionsschicht wird Strahlung auch im Bereich des sichtbaren Lichts erzeugt.

Vorteilhafterweise sind die mindestens zwei elektrisch leitfähigen Bahnen dabei in einem Abstand von 5 µm bis 10 cm, vorzugsweise von 500 µm bis 1 cm, auf der Elektrodenschicht, gegebenenfalls auch in unterschiedlicher Länge angeordnet. Sie können getrennt voneinander elektrisch angesteuert werden. Dazu sind in einer günstigen Ausgestaltung der Erfindung die elektrisch leitfähigen Bahnen elektrisch leitend mit einer Stromquelle verbunden, wobei ein Ausgangssignal der Stromquelle auf eine für jede Leiterbahn individuelle Modulationsfrequenz einstellbar sein kann. Diese Modulationsfrequenz beträgt zum Beispiel unter 200 Hz, vorzugsweise unter 100 Hz. Es ist auch eine statistisch fluktuierende Frequenz und/oder Amplitude vorstellbar.

Alternativ weisen die Leiterbahnen elektrische Anschlüsse zur Kontaktierung einer Stromquelle auf, wobei die Anschlüsse an unterschiedlichen Enden der Leiterbahnen vorhanden sein können.

Die Kontaktierung ist seitlich an der ersten Elektrodenfläche vorhanden. Damit kann die erste Elektrodenfläche mit Spannung versorgt werden. Die zumindest eine Funktionsschicht kann günstigerweise eine organische Funktionsschicht umfassen und vorzugsweise auch eine Ladungstransportschicht umfassen. Das Material der Funktionsschicht kann Polymere und/oder Small Molecules umfassen. Damit ist die strahlungsemittierende Vorrichtung eine organische, lichtemittierende Diode (OLED), die sich besonders gut als großflächiges Leuchtelement eignet.
Die zumindest eine Funktionsschicht kann auch eine anorganische Funktionsschicht sein, beispielsweise auf Phosphid- oder Nitrid-Verbindungshalbleitern basierend. Vorzugsweise sind das Materialien, die die allgemeine Formel AlₙGaₘIn₁₋ₙ₋ₘP umfassen, wobei 0 ≤ n ≤ 1, 0 ≤ m ≤ 1 und n+m ≤ 1 oder Nitrid-III/V-Verbindungshalbleiter, vorzugsweise die allgemeine Formel AlₙGaₘIn₁₋ₙ₋ₘN umfassend, wobei 0 ≤ n ≤ 1, 0 ≤ m ≤ 1 und n+m ≤ 1.
Das Material der ersten und/oder zweiten Elektrodenfläche umfasst in einer günstigen Ausführungsform Metalloxide. Transparente leitende Oxide (transparent conductive oxides, kurz "TCO") sind transparente, leitende Materialien, in der Regel Metalloxide, wie beispielsweise Zinkoxid, Zinnoxid, Cadmiumoxid, Titanoxid, Indiumoxid oder Indiumzinnoxid (ITO). Neben binären Metallsauerstoffverbindungen, wie beispielsweise ZnO, SnO₂ oder In₂O₃ gehören auch ternäre Metallsauerstoffverbindungen, wie beispielsweise Zn₂SnO₄, CdSnO₃, ZnSnO₃, MgIn₂O₄, GaInO₃, Zn₂In₂O₅ oder In₄Sn₃O₁₂ oder Mischungen unterschiedlicher transparenter leitender Oxide zu der Gruppe der TCOs. Weiterhin entsprechen die TCOs nicht zwingend einer stöchiometrischen Zusammensetzung und können auch p- oder n-dotiert sein. Ebenso können transparente Elektroden hochleitende organische Materialien wie PEDOT oder dotierte organische Schichten umfassen.

Die elektrisch leitfähigen Bahnen sind für die von der strahlungsemittierenden Vorrichtung emittierte Strahlung nicht transparent. Dennoch ist es vorteilhaft wenn sich diese von der Kontaktierung weg über die erste und/oder zweite Elektrodenfläche erstrecken. Ihre Verteilungsdichte nimmt günstigerweise mit größer werdendem Abstand von der Kontaktierung ab. Dazu ist es vorteilhaft, wenn benachbarte Leiterbahnen unterschiedliche Längen aufweisen und die Längenverteilung der Leiterbahnen ausgehend von der Kontaktierung zumindest ein Maximum und ein Minimum aufweist. Diese Ausführungsform hat den Vorteil, dass durch die variierende Verteilungsdichte in Abhängigkeit des Abstandes von der ersten und/oder dritten Kontaktierung die emittierte Strahlung derart modifiziert wird, dass die Leuchtdichteunterschiede, die ohne die eingebrachten Leiterbahnen vorhanden sind, ausgeglichen bzw. vermindert werden können. Durch die mit größer werdendem Abstand von der Kontaktierung abnehmende Verteilungsdichte der Leiterbahnen wird die Flächenabdeckung der ersten und/oder zweiten Elektrodenfläche so gering wie möglich gehalten.

Weiterhin ist es vorteilhaft, wenn die Breite der Leiterbahnen wenige Mikrometer, vorzugsweise weniger als 100 µm, besonders bevorzugt weniger als 20 µm beträgt. Das hat den Vorteil, dass die Leiterbahnen von einem äußeren Betrachter nicht mit bloßem Auge wahrgenommen werden können.
Weiterhin kann die Dicke der elektrisch leitfähigen Bahnen vorteilhafterweise einen Bereich von weniger als 100 µm aufweisen, vorzugsweise einen Bereich von 1 µm bis 3 µm. Damit verbindet sich der Vorteil, dass diese elektrisch auf der Oberfläche der ersten und/oder zweiten Elektrode vorhanden sein können und ebenso durch die gesamte Funktionsschicht hindurchreichen und diese durchstoßen können. In diesem Fall umgibt die Leiterbahnen eine isolierende Schicht, beispielsweise eine isolierende Polymerschicht. Dadurch werden Kurzschlüsse mit der jeweils anderen Elektrodenschicht vermieden.

Die Erfindung wird im Folgenden anhand eines Ausführungsbeispiels unter Zuhilfenahme von vier Figuren näher erläutert. Es zeigt:
- Figur 1: eine strahlungsemittierende Vorrichtung in einer schematischen Querschnittsdarstellung,
- Figur 2: elektrisch leitende Bahnen beziehungsweise Busbars in der Draufsicht einer strahlungsemittierenden Vorrichtung mit einer Ausschnittsvergrößerung,
- Figur 3: ein Oberflächenprofil einer elektrisch leitenden Bahn beziehungsweise Busbar in einer dreidimensionalen Darstellung,
- Figur 4: eine fotoähnliche Darstellung in perspektivischer Weise eines OLEDs mit siebgedruckten Leiterbahnen.

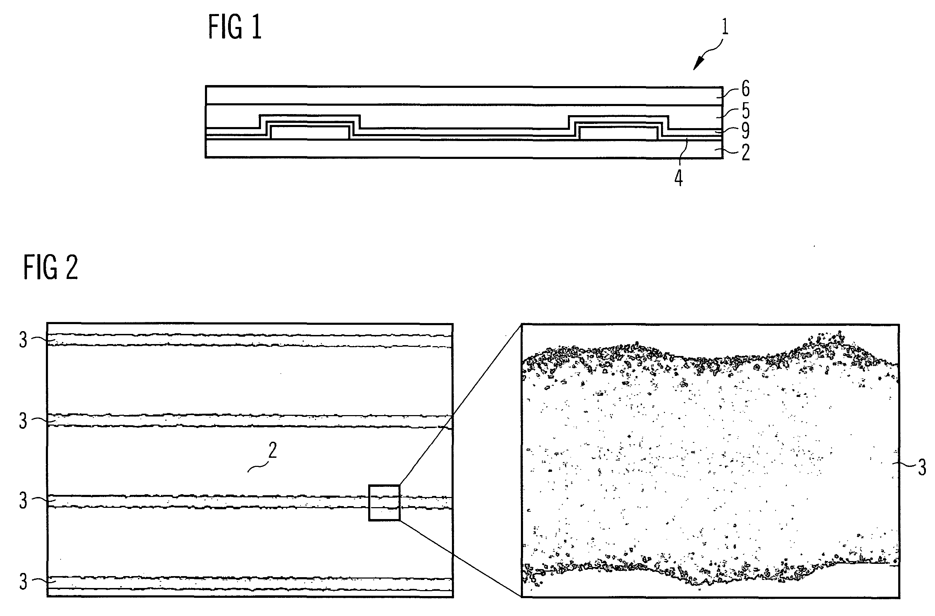

Die Figur 1 zeigt eine strahlungsemittierende Vorrichtung 1 in einer schematischen Querschnittsdarstellung, wobei der schichtartige Aufbau dargestellt ist. Auf ein strahlungstransparentes Substrat 2 sind elektrisch leitende Bahnen 3 aufgebracht. Dabei ist das Substrat 2 zum Beispiel aus einem transparenten Werkstoff gebildet und ist bevorzugt transparent für die von der strahlungsemittierenden Vorrichtung 1 emittierte Strahlung. Bevorzugt ist dies zum Beispiel Licht im sichtbaren Bereich. Die elektrisch leitenden Bahnen 3 sind aus elektrisch leitfähigen Partikeln gebildet, welche zueinander in elektrischem Kontakt stehen. Diese sind mittels eines Siebdruckverfahrens auf das strahlungstransparente Substrat 2 aufgebracht. Die Größe der einzelnen leitfähigen Partikel ist gleich oder kleiner als 1 µm. Vorzugsweise sind die einzelnen leitfähigen Partikel aus metallischem Werkstoff. Die elektrisch leitfähigen Bahnen 3 weisen dabei eine Dicke von 1 bis 3 µm und eine Breite von 50 bis 100 µm auf. Die elektrisch leitfähigen Bahnen 3, welche auch als Busbars bezeichnet werden, bilden einen elektrischen Kontakt mit einer ersten Elektrodenschicht 4, welche zum Beispiel als Anode bezeichnet ist.

Nachfolgend auf die erste Elektrodenschicht 4 ist im dargestellten Ausführungsbeispiel der Figur 1 eine Funktionsschicht 5 angeordnet. Die Funktionsschicht 5 ist aus einem organischen Material gebildet, welches unter dem Einfluss von elektrischem Strom und/oder elektrischer Spannung Licht emittierende Eigenschaften aufweist. Nachfolgend zur Funktionsschicht 5 ist eine zweite Elektrodenschicht 6 gebildet. Diese bildet eine Kathode. Die mittels des Siebdruckverfahrens aufgebrachten elektrisch leitfähigen Bahnen, die Busbars, weisen eine wesentlich höhere Dicke auf als die anderen Schichten der strahlungsemittierenden Vorrichtung. Die Busbars 3 des dargestellten Ausführungsbeispiels sind etwa 1-3 µm dick, während die Funktionsschicht und die Elektrodenschichten Dicken von etwa 200 nm aufweisen. Mittels nanoskaliger Siebdruckpasten sind Busbars in Schichtdicken von 100 - 500 nm herstellbar. Zur Vermeidung von Kurzschlüssen zwischen den elektrisch leitfähigen Bahnen 3, den Busbars 3, und der Kathodenschicht 6 ist die Funktionsschicht 5 und die erste Elektrodenschicht 4 über die Busbars 3 angeordnet, so dass diese Schichten die Busbars 3 überdecken. Somit ist ein Kurzschluss zwischen den Busbars 3 und der zweiten Elektrodenschicht 6 vermieden. In der Figur 1 ist dies aufgrund der rein schematischen Darstellung nicht maßgetreu abgebildet. Das dargestellte Ausführungsbeispiel zeigt weiter eine Schutzschicht 9, welche über den elektrisch leitfähigen Bahnen 3 angeordnet ist. Diese verhindert einerseits eine Oxidation der elektrisch leitfähigen Bahnen 3 während der nachfolgenden Prozessschritte des Herstellungsverfahrens und weist vorteilhafter Weise Eigenschaften eines elektrischen Halbleiters auf. Damit ist es möglich den Ladungsträgeraustausch an der Anode zu beeinflussen.
Die Figur 2 zeigt in einer Draufsicht und in einer Ausschnittsvergrößerung der Draufsicht eine mikroskopisch fotografische Aufnahme der per Siebdruckverfahren auf das Substrat 2 aufgetragenen elektrisch leitfähigen Bahnen 3, die Busbars 3. Die Ausschnittsvergrößerung zeigt, dass im Ergebnis nach einem abgetrockneten Druckprozess innerhalb der Busbars die Partikel Kontakt zueinander haben. Aufgrund der elektrischen Leitfähigkeit der Partikel ist somit eine elektrisch leitfähige Bahn ausgebildet, welche in einfacher und kostengünstiger Art und Weise auf dem Substrat auftragbar ist.

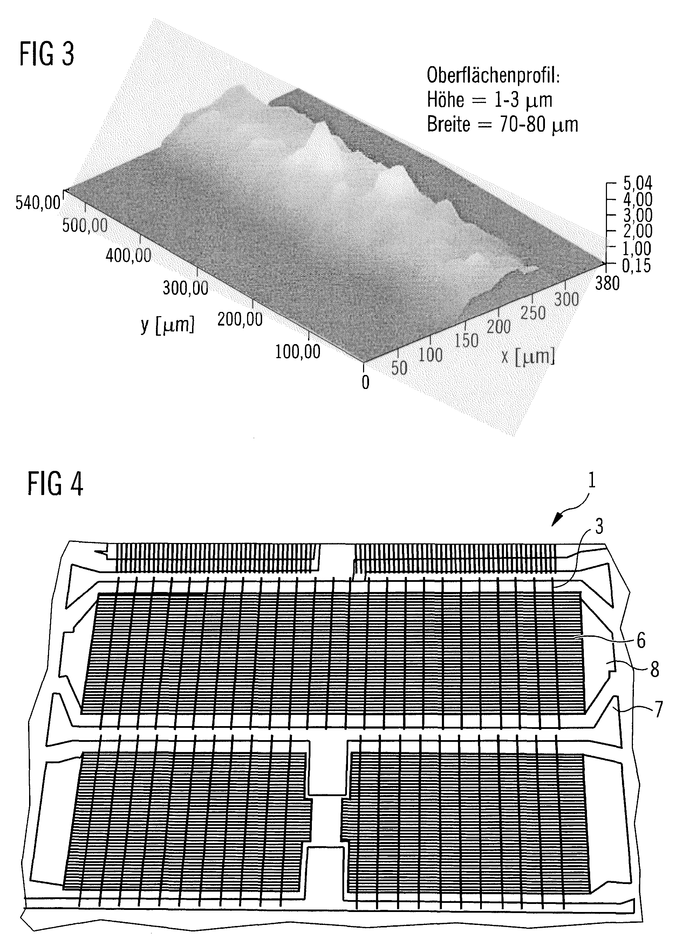

Die Figur 3 zeigt eine räumliche Darstellung in einem dreidimensionalen Diagramm einer mikroskopischen Aufnahme, welche eine der mittels des Siebdruckverfahrens auf das Substrat 2 aufgetragenen elektrisch leitfähigen Bahnen 3 zeigt.
Figur 4 zeigt eine fotoähnliche Darstellung eines Ausführungsbeispiels der strahlungsemittierenden Vorrichtung 1 gemäß dem Prinzip der Erfindung. Das dargestellte Ausführungsbeispiel ist eine organische LED (OLED) mit elektrisch leitfähigen Bahnen 3, welche per Siebdruck aufgebracht sind. Die elektrisch leitfähigen Bahnen 3 verlaufen in vertikaler Richtung von einer ersten Kontaktierung 7 über die gesamte Anodenfläche des OLEDs hinweg zu einer weiteren ersten Kontaktierung 7 und homogenisieren somit den Stromverlauf an der transparenten Anode. Die zweite Elektrodenschicht 6, die Kathode, ist hier ebenfalls sichtbar, da das Substrat 2 transparent ist. Weiter zeigt die Figur 4 eine zweite Kontaktierung 8, welche gemeinsam mit der ersten Kontaktierung 7 einen elektrischen Anschluss der strahlungsemittierenden Vorrichtung 1 ermöglicht. Die erste Kontaktierung 7 und die zweite Kontaktierung 8 sind ebenfalls mittels des Siebdruckverfahrens aufgebracht.

## Patentansprüche

1. Strahlungsemittierende Vorrichtung (1) umfassend,
- ein strahlungstransparentes Substrat (2),
- eine auf dem strahlungstransparenten Substrat (2) angeordnete Schichtfolge,
umfassend
- zumindest eine erste Elektrodenschicht (4),
- zumindest eine Funktionsschicht (5), welche im Betrieb Strahlung emittiert,
- zumindest eine zweite Elektrodenschicht (6), mit einer zweiten Kontaktierung (8) zum Anlegen einer elektrischen Spannung auf der Funktionsschicht (5),
wobei
- die Funktionsschicht (5) zwischen der ersten und der zweiten Elektrodenschicht (4/6) angeordnet ist,
- die erste Elektrodenschicht (4) zumindest eine elektrisch leitfähige Bahn (3) aufweist, welche mittels leitfähiger Partikel, welche zueinander in elektrischem Kontakt stehen, gebildet ist, und
- die elektrisch leitfähige Bahn mit einer strahlungstransparenten und elektrisch leitfähigen Schutzschicht aus anorganisch leitendem Oxid überdeckt ist,
**dadurch gekennzeichnet, dass**
- die erste Elektrodenschicht (4) eine erste, seitliche Kontaktierung (7) zum Anlegen einer elektrischen Spannung aufweist,
- die erste seitliche Kontaktierung (7) mittels leitfähiger Partikel gebildet ist, und
- die Schutzschicht eine Zinkoxidschicht ist.

2. Strahlungsemittierende Vorrichtung (1) nach Patentanspruch 1,
**dadurch gekennzeichnet, dass**
die leitfähigen Partikel zueinander verschmolzen sind.

3. Strahlungsemittierende Vorrichtung (1) nach einem der vorhergehenden Patentansprüche,
**dadurch gekennzeichnet, dass**
die leitfähigen Partikel kleiner als 1 µm sind.

4. Strahlungsemittierende Vorrichtung (1) nach einem der vorhergehenden Patentansprüche,
**dadurch gekennzeichnet, dass**
die leitfähigen Partikel aus Metall gebildet sind.

5. Strahlungsemittierende Vorrichtung (1) nach einem der vorhergehenden Patentansprüche,
**dadurch gekennzeichnet, dass**
die elektrisch leitfähige Bahn (3) eine Dicke von 1-3 µm aufweist.

6. Strahlungsemittierende Vorrichtung (1) nach einem der vorhergehenden Patentansprüche,
**dadurch gekennzeichnet, dass**
die elektrisch leitfähige Bahn (3) eine Dicke von 100-500 nm aufweist.

7. Strahlungsemittierende Vorrichtung (1) nach einem der vorhergehenden Patentansprüche,
**dadurch gekennzeichnet, dass**
die elektrisch leitfähige Bahn (3) eine Breite von 50-100 µm aufweist.

8. Strahlungsemittierende Vorrichtung (1) nach einem der vorhergehenden Patentansprüche,
**dadurch gekennzeichnet, dass** die erste Elektrodenschicht (4) eine Mehrzahl von elektrisch leitfähigen Bahnen (3) aufweist und ein an den elektrisch leitfähigen Bahnen erfolgende Ladungsträgeraustausch mittels der Zinkoxidschicht steuerbar ist.

9. Strahlungsemittierende Vorrichtung (1) nach einem der vorhergehenden Patentansprüche,
**dadurch gekennzeichnet, dass**
die elektrisch leitfähige Bahn (3) in elektrischem Kontakt mit der ersten Elektrodenschicht (4) steht.

10. Strahlungsemittierende Vorrichtung (1) nach einem der vorhergehenden Patentansprüche,
**dadurch gekennzeichnet, dass**
die erste Elektrodenschicht (4) mindestens zwei elektrisch leitfähige Bahnen aufweist und die Funktionsschicht (5) sowie die erste Elektrodenschicht (4) über den elektrisch leitfähigen Bahnen (3) angeordnet sind, so dass diese Schichten die elektrisch leitfähigen Bahnen (3) überdecken.

11. Strahlungsemittierende Vorrichtung (1) nach Anspruch 10, **dadurch gekennzeichnet, dass**
die elektrisch leitfähigen Bahnen (3) individuell elektronisch ansteuerbar sind.

12. Strahlungsemittierende Vorrichtung (1) nach einem der vorhergehenden Patentansprüche,
**dadurch gekennzeichnet, dass**
sich zwischen den beiden Elektrodenschichten (4/6) mindestens eine organische funktionelle Schicht (5) befindet.

13. Verfahren zur Herstellung einer strahlungsemittierenden Vorrichtung gemäß einem der Patentansprüche 1 bis 12,
mit den Verfahrensschritten
Anordnen einer Schichtfolge auf einem Substrat (2),
wobei
zumindest eine elektrisch leitende Bahn (3) mittels eines Siebdruckvorgangs, auf die erste Elektrodenschicht (4) aufgebracht wird,
wobei zu dem Siebdruckvorgang eine Suspension mit leitfähigen Partikeln verwendet wird und dem Druckvorgang ein thermischer Prozess nachgeordnet ist, bei dem durch eine Temperaturerhöhung die in der Suspension enthaltenen Lösungsmittel entfernt und die einzelnen leitfähigen Partikel miteinander verschmolzen werden.

14. Verfahren nach dem vorhergehenden Anspruch,
**dadurch gekennzeichnet, dass**
nachfolgend dem Druckvorgang und/oder dem thermischen Prozess die Schutzschicht (9) aufgebracht wird, wobei die Schutzschicht (9) aus Zinkoxid in einer alkohol-basierten Lösung gebildet wird.

## Claims

1. Radiation-emitting device (1) comprising
- a radiation-transparent substrate (2),
- a layer sequence arranged on the radiation-transparent substrate (2),
comprising
- at least one first electrode layer (4),
- at least one functional layer (5) which emits radiation during operation,
- at least one second electrode layer (6), having a second contact-connection (8) for applying an electrical voltage on the functional layer (5),
wherein
- the functional layer (5) is arranged between the first and second electrode layers (4/6),
- the first electrode layer (4) has at least one electrically conductive track (3) formed by means of conductive particles that are in electrical contact with one another, and
- the electrically conductive track is covered with a radiation-transparent and electrically conductive protective layer composed of inorganically conducting oxide,
**characterized in that**
- the first electrode layer (4) has a first, lateral contact-connection (7) for applying an electrical voltage,
- the first lateral contact-connection (7) is formed by means of conductive particles, and
- the protective layer is a zinc oxide layer.

2. Radiation-emitting device (1) according to Patent Claim 1,
**characterized in that**
the conductive particles are fused together.

3. Radiation-emitting device (1) according to either of the preceding patent claims,
**characterized in that**
the conductive particles are smaller than 1 µm.

4. Radiation-emitting device (1) according to any of the preceding patent claims,
**characterized in that**
the conductive particles are formed from metal.

5. Radiation-emitting device (1) according to any of the preceding patent claims,
**characterized in that**
the electrically conductive track (3) has a thickness of 1-3 µm.

6. Radiation-emitting device (1) according to any of the preceding patent claims,
**characterized in that**
the electrically conductive track (3) has a thickness of 100-500 nm.

7. Radiation-emitting device (1) according to any of the preceding patent claims,
**characterized in that**
the electrically conductive track (3) has a width of 50-100 µm.

8. Radiation-emitting device (1) according to any of the preceding patent claims,
**characterized in that** the first electrode layer (4) has a plurality of electrically conductive tracks (3) and a charge carrier exchange effected at the electrically conductive tracks is controllable by means of the zinc oxide layer.

9. Radiation-emitting device (1) according to any of the preceding patent claims,
**characterized in that**
the electrically conductive track (3) is in electrical contact with the first electrode layer (4).

10. Radiation-emitting device (1) according to any of the preceding patent claims,
**characterized in that**
the first electrode layer (4) has at least two electrically conductive tracks and the functional layer (5) and also the first electrode layer (4) are arranged above the electrically conductive tracks (3), such that said layers cover the electrically conductive tracks (3).

11. Radiation-emitting device (1) according to Claim 10, **characterized in that**
the electrically conductive tracks (3) are individually electronically driveable.

12. Radiation-emitting device (1) according to any of the preceding patent claims,
**characterized in that**
at least one organic functional layer (5) is situated between the two electrode layers (4/6).

13. Method for producing a radiation-emitting device according to any of Patent Claims 1 to 12,
comprising the method steps of
arranging a layer sequence on a substrate (2)
wherein
at least one electrically conductive track (3) is applied to the first electrode layer (4) by means of a screen printing process,
wherein a suspension comprising conductive particles is used for the screen printing process and the printing process is followed by a thermal process in which, by means of an increase in temperature, the solvents contained in the suspension are removed and the individual conductive particles are fused together.

14. Method according to the preceding claim,
**characterized in that**
following the printing process and/or the thermal process, the protective layer (9) is applied, wherein the protective layer (9) is formed from zinc oxide in an alcohol-based solution.

## Revendications

1. Emetteur de rayonnement (1) comprenant :
un substrat (2) transparent vis-à-vis du rayonnement,
une succession de couches disposées sur le substrat (2) transparent vis-à-vis du rayonnement et comprenant :
au moins une première couche d'électrode (4),
au moins une couche fonctionnelle (5) qui émet un rayonnement en fonctionnement,
au moins une deuxième couche d'électrode (6) avec un deuxième contact (8) permettant d'appliquer une tension électrique sur la couche fonctionnelle (5),
la couche fonctionnelle (5) étant disposée entre la première et la deuxième couche d'électrode (4/6),
la première couche d'électrode (4) présentant au moins une piste électriquement conductrice (3) formée de particules conductrices en contact électrique mutuel, et
la piste électriquement conductrice est recouverte d'une couche de protection transparente vis-à-vis du rayonnement et électriquement conductrice en oxyde anorganiquement conducteur ;
**caractérisé en ce que**
la première couche d'électrode (4) présente un premier contact latéral (7) permettant d'appliquer une tension électrique,
**en ce que** le premier contact latéral (7) est formé de particules conductrices et
**en ce que** la couche de protection est une couche d'oxyde de zinc.

2. Emetteur de rayonnement (1) selon la revendication 1, **caractérisé en ce que** les particules conductrices sont fondues les unes par rapport aux autres.

3. Emetteur de rayonnement (1) selon l'une des revendications précédentes, **caractérisé en ce que** les particules conductrices ont une taille inférieure à 1 µm.

4. Emetteur de rayonnement (1) selon l'une des revendications précédentes, **caractérisé en ce que** les particules conductrices sont formées de métal.

5. Emetteur de rayonnement (1) selon l'une des revendications précédentes, **caractérisé en ce que** la piste électriquement conductrice (3) a une épaisseur de 1 à 3 µm.

6. Emetteur de rayonnement (1) selon l'une des revendications précédentes, **caractérisé en ce que** la piste électriquement conductrice (3) a une épaisseur de 100 à 500 nm.

7. Emetteur de rayonnement (1) selon l'une des revendications précédentes, **caractérisé en ce que** la piste électriquement conductrice (3) a une largeur de 50 à 100 µm.

8. Emetteur de rayonnement (1) selon l'une des revendications précédentes, **caractérisé en ce que** la première couche d'électrode (4) comporte une pluralité de pistes électriquement conductrices (3) et qu'un échange de porteur de charge se produisant au niveau des pistes électriquement conductrices peut être commandé au moyen de la couche d'oxyde de zinc.

9. Emetteur de rayonnement (1) selon l'une des revendications précédentes, **caractérisé en ce que** la piste électriquement conductrice (3) est en contact électrique avec la première couche d'électrode (4).

10. Emetteur de rayonnement (1) selon l'une quelconque des revendications précédentes, **caractérisé en ce que** la première couche d'électrode (4) comporte au moins deux pistes électriquement conductrices et que la couche fonctionnelle (5) ainsi que la première couche d'électrode (4) sont disposées au-dessus des pistes électriquement conductrices (3), de sorte que ces couches recouvrent les pistes électriquement conductrices (3).

11. Emetteur de rayonnement (1) selon la revendication 10, **caractérisé en ce que** les pistes électriquement conductrices (3) peuvent être commandées électroniquement une par une.

12. Emetteur de rayonnement (1) selon l'une des revendications précédentes, **caractérisé en ce qu'**au moins une couche fonctionnelle organique (5) est située entre les deux couches d'électrode (4/6).

13. Procédé de fabrication d'un émetteur de rayonnement selon l'une des revendications 1 à 12, avec les étapes de procédé :
disposer une succession de couches sur un substrat (2),
au moins une piste électriquement conductrice (3) étant appliquée sur la première couche d'électrode (4) par une opération de sérigraphie,
une suspension de particules conductrices étant utilisée pour l'opération de sérigraphie et l'opération d'impression étant suivie par un traitement thermique dans lequel le solvant que contient la suspension est éliminé par augmentation de la température et les différentes particules conductrices sont fondues les unes par rapport aux autres.

14. Procédé selon la revendication précédente, **caractérisé en ce qu'**après l'opération d'impression et/ou l'opération thermique, la couche de protection (9) est appliquée, la couche de protection (9) étant formée d'oxyde de zinc en solution à base d'alcool.
